# EUROPEAN PATENT SPECIFICATION

(11) **EP 3 113 217 B1**
(45) Date of publication and mention of the grant of the patent: **11.03.2020**
(21) Application number: 14859331.2
(22) Date of filing: 18.03.2014
(51) Int. Cl.: H01L 21/336, H01L 29/786, H01L 27/12

(54) **LOW-TEMPERATURE POLYCRYSTALLINE SILICON THIN-FILM TRANSISTOR, ARRAY SUBSTRATE AND MANUFACTURING METHOD THEREFOR**
NIEDRIGTEMPERATUR-DÜNNSCHICHTTRANSISTOR AUS POLYKRISTALLINEM SILICIUM, ARRAYSUBSTRAT UND HERSTELLUNGSVERFAHREN DAFÜR
TRANSISTOR À COUCHES MINCES AU SILICIUM POLYCRISTALLIN À BASSE TEMPÉRATURE, SUBSTRAT MATRICIEL ET LEUR PROCÉDÉ DE FABRICATION

(30) Priority: 24.02.2014 CN 201410062345
(43) Date of publication of application: 04.01.2017
(73) Proprietor: BOE Technology Group Co., Ltd., Beijing 100015 (CN)
(72) Inventor: MAO, Xue, Beijing 100176 (CN)
(74) Representative: Isarpatent
(86) International application number: PCT/CN2014/073615
(87) International publication number: WO 2015/123903

(56) References cited:
- JP-A- H1 079 514
- JP-A- H05 235 031
- JP-A- H08 242 001
- US-A- 5 953 598
- US-A1- 2001 000 011
- US-A1- 2006 017 052
- US-A1- 2006 097 319
- US-A1- 2007 029 614
- US-B1- 6 562 667

## Description

### TECHNICAL FIELD

The present disclosure relates to the field of thin film transistor (TFT) manufacturing process, in particular to a low temperature poly-silicon (LTPS) TFT, an array substrate, and their manufacturing methods.

### BACKGROUND

TFTs have been used in pixel units for various display devices so as to drive the display devices by applying a driving voltage, and an a-Si material with excellent stability and processability has always been used for an active layer of the TFT. However, the a-Si material has low carrier mobility, and cannot meet the requirements of a large-size and high-resolution display device, especially a next-generation AMOLED (active matrix organic light-emitting diode) display device. As compared with the a-Si TFT, a poly-silicon TFT, especially an LTPS TFT, has higher carrier mobility, better liquid crystal characteristics and lower leakage current, thus it has gradually replaced the a-Si TFT and become a mainstream of the TFTs.

In the related art, an active region is formed by ion injection subsequent to the formation of a poly-silicon layer. After the ion injection, doped impurities at the active region are usually positioned on an interstitial lattice site, and thus it is impossible to provide carriers. It is required to activate the ions injected into the poly-silicon layer by a thermal annealing process, so as to recover integrity of the lattices. It can be seen that, in the related art, three steps are desired for the formation of the poly-silicon layer and the active region, so the process thereof is complex. In addition, the thermal annealing process is performed at a high temperature, so it cannot be adapted to the formation of the TFT on a flexible substrate.

US 2006/017052 discloses a method for manufaturing a LTPS TFT with an additional annealing step before the excimer laser annealing.

### SUMMARY

An object of the present disclosure is to provide an LTPS TFT, an array substrate and their manufacturing methods, so as to simplify a process for manufacturing the LTPS TFT.

In one aspect, the present disclosure provides in embodiments a method for manufacturing an LTPS TFT according to the independent claim.

Alternatively, the excimer laser annealing treatment is performed at a laser pulse frequency of 100 to 400 Hz, a laser overlapping ratio of 90% to 98%, a laser pulse width of less than 100 ns, and a laser energy density of 100 to 600 mJ/cm².

Alternatively, subsequent to forming the a-Si layer and prior to injecting the foreign ions, the method further includes subjecting the a-Si layer to thermal annealing treatment.

Alternatively, prior to forming the a-Si layer, the method further includes forming a buffer layer on the substrate so as to cover the entire substrate.

Alternatively, the foreign ion is a boron or phosphorus ion.

Alternatively, the substrate is a flexible substrate.

In another aspect, the present provides in embodiments a method for manufacturing an array substrate, including steps of forming an LTPS TFT on a substrate and forming a lower electrode of a storage capacitor. The LTPS TFT is formed by the above-mentioned method.

Alternatively, the step of forming the lower electrode of the storage capacitor includes: injecting foreign ions into a region of the a-Si layer where the lower electrode of the storage capacitor is to be formed while injecting foreign ions into the region of the a-Si layer where the ohmic contact layer is to be formed by ion injection, so as to enable a lower electrode of an initial storage capacitor to be formed at the region where the lower electrode of the storage capacitor is to be formed.

According to the method for manufacturing the LTPS TFT in the above-mentioned embodiments, the ion injection is performed prior to the formation of the poly-silicon layer, and the ohmic contact layer is formed during the formation of the poly-silicon layer, i.e., the ohmic contact layer is formed during the excimer laser annealing treatment, as a result, it is able to simplify the manufacturing process. In addition, the foreign ions for the ohmic contact layer are doped through the excimer laser annealing treatment in a drive-in diffusion manner, thereby to prevent the occurrence of defects and imperfections of the TFT due to the ion injection and to improve the performance of the TFT.

### BRIEF DESCRIPTION OF THE DRAWINGS

Fig.1 is a flow chart of a method for manufacturing an array substrate according to an embodiment of the present disclosure;
Fig.2 is a schematic view showing a substrate with a buffer layer according to an embodiment of the present disclosure;
Fig.3 is a schematic view showing the substrate with an a-Si layer according to an embodiment of the present disclosure;
Fig.4 is a schematic view showing the substrate with an initial ohmic contact layer according to an embodiment of the present disclosure;
Fig.5 is a schematic view showing the substrate with an active layer according to an embodiment of the present disclosure;
Fig.6 is a schematic view showing the substrate with a gate insulating layer, a gate electrode and an upper electrode of a storage capacitor according to an embodiment of the present disclosure;
Fig.7 is a schematic view showing the substrate with a first insulating layer, an ohmic contact layer, a lower electrode lead according to an embodiment of the present disclosure; and
Fig.8 is a schematic view showing the substrate with a second insulating layer and a pixel electrode according to an embodiment of the present disclosure.

### DETAILED DESCRIPTION

The present disclosure provides in the following embodiments an LTPS TFT, an array substrate and their manufacturing methods, so as to simplify a process for manufacturing the LTPS TFT and improve the performance of the LTPS TFT.

According to the method for manufacturing the LTPS TFT in embodiments of the present disclosure, ions are injected into an a-Si layer prior to the formation of a poly-silicon layer, so as to form an initial ohmic contact layer, and an ohmic contact layer with the ions being activated is formed during the formation of the poly-silicon layer, so it is able to simplify the manufacturing process.

In embodiments of the present disclosure, "ohmic contact layer" is also referred to as a source/drain electrode doped layer, and it includes two regions independent of each other, which are electrically connected to a subsequently-formed source electrode and a subsequently-formed drain electrode, respectively.

The present disclosure provides in embodiments a method for manufacturing an LTPS TFT, including a step of forming an active layer and an ohmic contact layer on a substrate. The step of forming the active layer and the ohmic contact layer on the substrate includes:
forming an a-Si layer on the substrate;
injecting foreign ions into a region of the a-Si layer where the ohmic contact layer is to be formed by ion injection, so as to form an initial ohmic contact layer at the region where the ohmic contact layer is to be formed;
subjecting the a-Si layer obtained after the ion injection to excimer laser annealing treatment so as to crystallize the a-Si layer into a poly-silicon layer and enable the initial ohmic contact layer to form the final ohmic contact layer; and
patterning the poly-silicon layer obtained after the excimer laser annealing treatment, so as to form the active layer.

It should be appreciated by those skilled in the art that, the method for manufacturing the LTPS TFT further includes at least a step of forming a gate insulating layer and a gate electrode on the substrate, which is not particularly defined herein.

The present disclosure further provides in an embodiment a method for manufacturing an array substrate, including steps of forming an LTPS TFT on a substrate and forming a lower electrode of a storage capacitor, wherein the step of forming the LTPS TFT at least includes forming an active layer and an ohmic contact layer on the substrate, wherein the step of forming the active layer and the ohmic contact layer includes:
forming an a-Si layer on the substrate;
injecting foreign ions into a region of the a-Si layer where the ohmic contact layer is to be formed by ion injection, so as to form an initial ohmic contact layer at the region where the ohmic contact layer is to be formed;
subjecting the a-Si layer obtained after the ion injection to excimer laser annealing treatment so as to crystallize the a-Si layer into a poly-silicon layer and enable the initial ohmic contact layer to form the final ohmic contact layer; and
patterning the poly-silicon layer obtained after the excimer laser annealing treatment, so as to form the active layer.

Alternatively, the step of forming the lower electrode of the storage capacitor includes: injecting foreign ions into a region of the a-Si layer where the lower electrode of the storage capacitor is to be formed while injecting foreign ions into the region of the a-Si layer where the ohmic contact layer is to be formed by ion injection, so as to enable a lower electrode of an initial storage capacitor to be formed at the region where the lower electrode of the storage capacitor is to be formed.

The lower electrode of the storage capacitor is manufactured on the array substrate by a single patterning process at the same time with partial procedures of manufacturing the TFT. The procedures of manufacturing the TFT and the lower electrode of the storage capacitor on the array substrate will be described hereinafter.

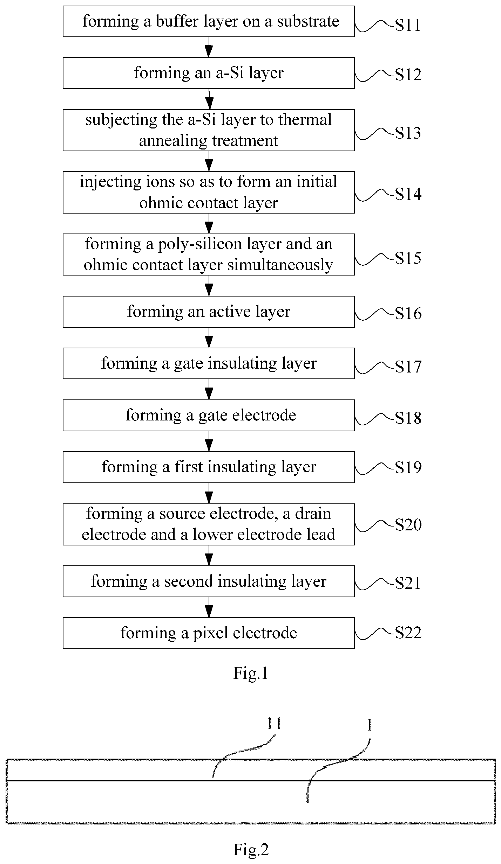

Referring to Fig.1, in an alternative embodiment, the method for manufacturing the array substrate includes the following steps.

Step S11: forming a buffer layer on the substrate. When the cleanliness of the substrate does not meet a predetermined requirement, the substrate may be subjected to pre-cleaning treatment in accordance with the practical need, and the buffer layer for covering the entire substrate may be formed on the substrate by a coating process. To be specific, referring to Fig.2, the buffer layer 11 is formed on the substrate 1.

Step S11 is an optional one. The buffer layer formed in Step S11 may improve an adhesion degree between the a-Si layer to be formed and the substrate. Meanwhile, it may also prevent metallic ions in the substrate from diffusing toward the ohmic contact layer, and reduce generation of leakage current. A material of the substrate is not particularly defined herein. For example, the substrate may be a glass substrate or a flexible substrate.

As an alternative mode, in Step S11, the buffer layer having a thickness of 2000 to 3000Å is deposited on the glass substrate by plasma enhanced chemical vapor deposition (PECVD). A single-layered structure consisting of a SiOₓ or SiNₓ film layer, or a multi-layered structure consisting of both SiOₓ and SiNₓ film layers, may be deposited.

A reacting gas for forming the SiNₓ film layer may be a mixture of SiH₄, NH₃ and N₂, or a mixture of SiH₂Cl₂, NH₃ and N₂. A reacting gas for forming the SiOₓ film layer may be a mixture of SiH₄, NH₃ and O₂, or a mixture of SiH₂Cl₂, NH₃ and O₂.

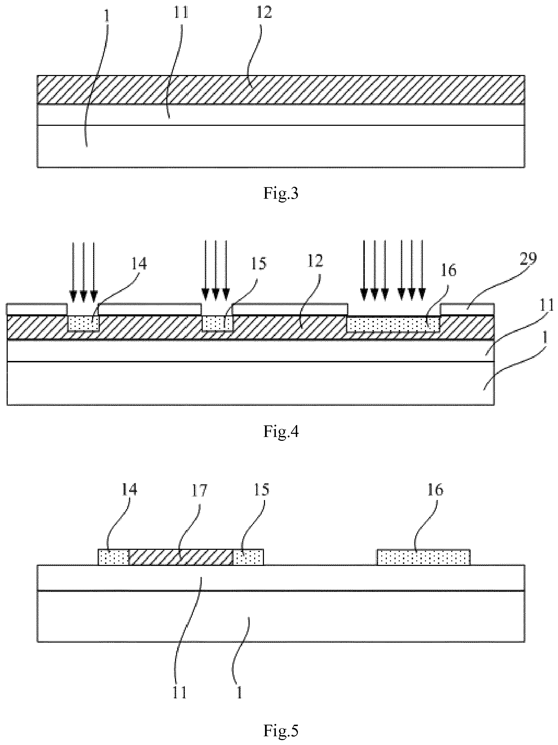

Step S12: forming an a-Si layer. The a-Si layer for covering the entire substrate (or the buffer layer) may be formed on the substrate (or the buffer layer) by a coating process. In this embodiment, because the buffer layer has been formed on the substrate, as shown in Fig.3, the a-Si layer 12 for covering the entire buffer layer 11 is formed on the buffer layer 11 shown as Fig.2 by a coating process in Step S12.

As an alternative mode, in Step S12, the a-Si layer having a thickness of 300 to 1000Å may be deposited on the substrate (or the buffer layer). A reacting gas used for the deposition may be a mixture of SiH₄ and H₂, or a mixture of SiH₂Cl₂ and H₂. The a-Si layer obtained in Step S12 is used for forming a poly-silicon layer in Step S15 below.

Step S13: subjecting the a-Si layer to thermal annealing treatment. The a-Si layer is subjected to the thermal annealing treatment, so as to remove H₂ in the a-Si layer, thereby to prevent the occurrence of hydrogen explosion during the laser annealing treatment in a subsequent step.

A temperature for the thermal annealing treatment may be set in accordance with the practical need. When a glass substrate is used, a high temperature may be set for the thermal annealing treatment. When a flexible substrate is used, a low temperature may be set for the thermal annealing treatment, as long as the performance of the flexible substrate is not adversely affected. Step S13 is also an optional one.

Step S14: injecting ions into a region where the ohmic contact layer is to be formed by ion injection. A pattern of an n-type or p-type doped region is formed on the a-Si layer shown as Fig.3 by a patterning process, and the ions are injected into the n-type or p-type doped region by ion injection, so as to form patterns of a first initial ohmic contact layer 14 and a second initial ohmic contact layer 15, shown as Fig.4. The injected ions may be Boron or Phosphorus ions, and arrows in Fig.4 represent an injection direction of the ions. The ions injected into the a-Si layer are inactivated ions, i.e., these ions cannot function as donors or acceptors. To be specific, referring to Fig.4, the ions are injected into a region of the a-Si layer where the first initial ohmic contact layer and the second initial ohmic contact layer are to be formed by using a photoresist layer 29 as a mask plate.

Step S15: forming the poly-silicon layer and the ohmic contact layer simultaneously through excimer laser annealing treatment. The substrate with the a-Si layer, the first initial ohmic contact layer and the second initial ohmic contact layer, or further a lower electrode of an initial storage capacitor, is subjected to the excimer laser annealing treatment, so as to crystallize the a-Si layer into the poly-silicon layer, active the ions in the initial ohmic contact layer and enable the initial ohmic contact layer to form the final ohmic contact layer. The first initial ohmic contact layer and the second initial ohmic contact layer are collectively referred to as the initial ohmic contact layer.

In step S15, the poly-silicon layer is formed and the ions are activated through the single excimer laser annealing treatment. As a result, it is able to simplify the process due to the use of a thermal annealing process, and to prevent the formation of a flexible display device from being limited when the substrate is heated due to the ion activation during the thermal annealing treatment. In addition, due to a high local temperature of the excimer laser annealing treatment, it is able to improve the integrity of the lattices in the poly-silicon layer.

Through Step S15, it is able to simplify the process for manufacturing the LTPS TFT, improve the performance of the TFT and facilitate the manufacture of the flexible display device. In this embodiment, an excimer laser (with a wavelength of 308nm) using XeCl, KrF or ArF may be used in the excimer laser annealing treatment. After passing through an optical system, a laser beam becomes a linear light source. Alternatively, the excimer laser annealing treatment is performed at a laser pulse frequency of 100 to 400 Hz, a laser overlapping ratio of 90% to 98%, a laser pulse width of less than 100 ns, and a laser energy density of 100 to 600 mJ/cm².

As compared with a thermal annealing process, when the a-Si layer is converted into the poly-silicon layer by an excimer laser annealing treatment according to embodiments of the present disclosure, it is able to manufacture the LTPS TFT on the flexible substrate, and to provide the TFT with stable performances.

During the excimer laser crystallization (ELA), a position of the laser beam is constant, and the substrate is fixed onto a translation stage. A radiation range of the laser beam is controlled by moving the substrate, so that a predetermined region of the substrate is scanned by the laser beam. Under the radiation of the laser beam, the a-Si layer and Boron or Phosphorus molecules are melted by absorbing laser energy. At this time, melted Boron or Phosphorus molecules are doped into the melted silicon in a drive-in diffusion manner. During a cooling procedure, the laser-assisted doping is completed when the a-Si layer is crystallized into the poly-silicon layer, so as to form a Boron-doped or Phosphorus-doped poly-silicon region. The Boron-doped or Phosphorus-doped poly-silicon region is just a region where the ohmic contact layer is located. In this procedure, when the a-Si layer and Boron or Phosphorus molecules are melted by absorbing the laser energy under the radiation of laser beam, the melted Boron or Phosphorus molecules are doped into the melted silicon at a rapid rate in a drive-in diffusion manner, and the density of Boron or Phosphorus molecules distributed adjacent to an upper surface of the a-Si layer is similar to that distributed away from the upper surface of the a-Si layer, i.e., there is a relatively small density distribution gradient of the Boron or Phosphorus molecules from the upper surface of the a-Si layer to a lower surface of the a-Si layer. As a result, the resultant ohmic contact layer has excellent conductivity.

Step S16: forming the active layer. The poly-silicon layer obtained in Step S15 is patterned so as to form the active layer at a predetermined region. During the implementation, referring to Fig.5, the active layer 17 is formed by a photolithography process. To be specific, a photoresist is used as a mask plate, and the active layer 17 is formed after a dry etching process and the removal of the photoresist. In embodiments of the present disclosure, the active layer is also referred to as a poly-silicon island.

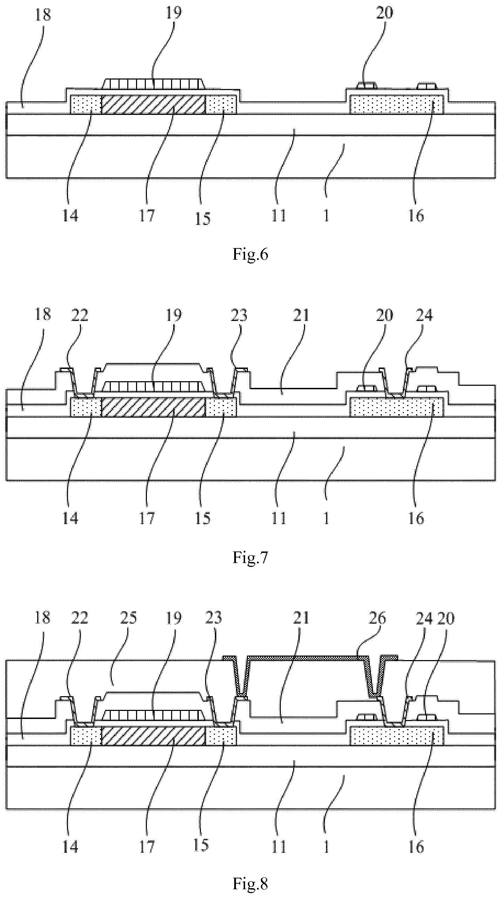

Step S17: forming the gate insulating layer. Referring to Fig.6, the gate insulating (GI) layer 18 having a thickness of 1000 to 2000Å is deposited by PECVD. The GI layer 18 may be a single layer made of SiNₓ or a double-layered structure consisting of SiNₓ and SiOₓ stacked films.

Step S18: forming the gate electrode. Referring to Fig.6, a gate metal or alloy layer having a thickness of 1500 to 2500Å is deposited by sputtering. The metal or alloy layer may be made of Mo, Al, Cu or W, or an alloy consisting of at least two of Mo, Al, Cu and W. Then, a pattern of the gate electrode 19 is formed on the gate metal or alloy layer by a patterning process.

Step S19: forming a first insulating layer. As shown in Fig.7, the first insulating layer 21 is formed on the gate electrode so as to cover the entire substrate. To be specific, an insulating layer having a thickness of 1000 to 3000Å is deposited by PECVD. The insulating layer may be made of SiNₓ or SiOₓ. Then, via-holes, in communication with the first initial ohmic contact layer 14 and the second initial ohmic contact layer 15, respectively, are formed after a photolithography process and a dry etching process.

The LTPS TFT is formed through the above Steps S11 to S19.

Further, subsequent to the formation of the LTPS TFT through Steps S11 to S19, the method for manufacturing the array substrate further includes a step of forming patterns of the lower electrode 16 and the upper electrode 20 of the storage capacitor.

Alternatively, for the poly-silicon layer, subsequent to Step S14 of injecting the ions into the region where the first initial ohmic contact layer and the second initial ohmic contact layer are to be formed, ions are further injected into a region where the lower electrode of the storage capacitor is to be formed, so as to form the lower electrode 16 of the initial storage capacitor.

The lower electrode of the storage capacitor is formed by doping foreign ions in the a-Si layer, i.e., the foreign ions (B or P ions) are injected into the region of the a-Si layer where the lower electrode of the storage capacitor is to be formed, so as to convert the semiconductive a-Si layer into a conductive layer.

Alternatively, during the formation of the pattern of the gate electrode 19 by a patterning process, Step S18 further includes forming the pattern of the upper electrode 20 of the storage capacitor right above the lower electrode of the storage capacitor. Then, the lower electrode and the upper electrode form the storage capacitor together.

Step S20: forming a source electrode, a drain electrode and a lower electrode lead. As shown in Fig.7, the source electrode 22, the drain electrode 23 and the lower electrode lead 24 of the storage capacitor electrically connected to the first initial ohmic contact layer 14 and the second initial ohmic contact layer 15 are formed in Step S20.

To be specific, a metal or alloy layer having a thickness of 2000 to 3000Å is deposited by sputtering or thermal evaporation. The metal or alloy layer may be made of Mo, Al, Cu or W, or an alloy thereof. Then, the source electrode 22, the drain electrode 23 and the lower electrode lead 24 of the storage capacitor are formed after a photolithography process and an etching process, as shown in Fig.7.

Step S21: forming a second insulating layer. As shown in Fig.8, the second insulating layer 25 is formed on the source electrode 22, the drain electrode 23 and the lower electrode lead 24 in Step S21. To be specific, the second insulating layer having a thickness of 1000 to 3000Å is deposited by PECVD. The second insulating layer may be made of SiNₓ or SiOₓ. Then, via-holes, in communication with the drain electrode 23 and the lower electrode lead 24, respectively, are formed by a photolithography process and a dry etching process. In addition, the second insulating layer may also be made of photosensitive, insulating resin.

Step S22: forming the pixel electrode. As shown in Fig.8, the pixel electrode 26, connected to the drain electrode and the lower electrode of the storage capacitor through the via-holes, respectively, is formed on the second insulating layer 25 in Step S22. To be specific, a transparent conductive film having a thickness of 500 to 1500Å is deposited by magnetron sputtering. The transparent conductive film may be made of ITO, IZO or AlZO. Then, an exposure process is performed using a conventional mask plate, and the pixel electrode is then formed after a development process and a wet etching process.

The present disclosure provides in embodiments the LTPS TFT manufactured by the above-mentioned LTPS TFT manufacturing method.

The present disclosure further provides in embodiments the array substrate manufactured by the above-mentioned array substrate manufacturing method.

According to the method for manufacturing the LTPS TFT in the above-mentioned embodiments, the ion injection is performed prior to forming the poly-silicon layer, and the ohmic contact layer is formed during the formation of the poly-silicon layer, i.e., the ohmic contact layer formed during the excimer laser annealing treatment. As a result, it is able to simplify the manufacturing process and inject the impurity ions for the ohmic contact layer through the excimer laser annealing treatment, thereby to prevent the occurrence of defects and imperfections of the TFT due to the ion injection and to improve the performance of the TFT.

## Claims

1. A method for manufacturing a low temperature poly-silicon (LTPS) thin film transistor (TFT), comprising a step of forming an active layer and an ohmic contact layer on a substrate, wherein the step of forming the active layer and the ohmic contact layer on the substrate comprises:
forming an a-Si layer on the substrate;
injecting foreign ions into a region of the a-Si layer where the ohmic contact layer is to be formed by ion injection, so as to form an initial ohmic contact layer at the region where the ohmic contact layer is to be formed, and refraining injecting the foreign ions into other region of the a-Si layer corresponding to a region occupied by the LTPS TFT in addition to the region of the a-Si layer where the ohmic contact layer is to be formed;
subjecting the a-Si layer obtained after the ion injection without an annealing step in between to excimer laser annealing treatment so as to crystallize the a-Si layer into a poly-silicon layer, activate the injected ions and enable the initial ohmic contact layer to form the final ohmic contact layer; and
patterning the poly-silicon layer obtained after the excimer laser annealing treatment, so as to form the active layer, wherein in the region occupied by the LTPS TFT, the poly-silicon layer located at a side of the ohmic contact layer away from the active layer is completely removed.

2. The method according to claim 1, wherein the excimer laser annealing treatment is performed at a laser pulse frequency of 100 to 400 Hz, a laser overlapping ratio of 90% to 98%, a laser pulse width of less than 100 ns, and a laser energy density of 100 to 600 mJ/cm².

3. The method according to claim 1 or 2, wherein subsequent to forming the a-Si layer and prior to injecting the foreign ions, the method further comprises subjecting the a-Si layer to thermal annealing treatment.

4. The method according to any one of claims 1 to 3, wherein prior to forming the a-Si layer, the method further comprises forming a buffer layer on the substrate so as to cover the entire substrate.

5. The method according to any one of claims 1 to 4, wherein the foreign ion is a boron or phosphorus ion.

6. The method according to any one of claims 1 to 5, wherein the substrate is a flexible substrate.

7. A method for manufacturing an array substrate, comprising steps of forming an LTPS TFT on a substrate and forming a lower electrode of a storage capacitor, wherein the LTPS TFT is formed by the method according to any one of claims 1 to 6.

8. The method according to claim 7, wherein the step of forming the lower electrode of the storage capacitor comprises injecting foreign ions into a region of the a-Si layer where the lower electrode of the storage capacitor is to be formed while injecting foreign ions into the region of the a-Si layer where the ohmic contact layer is to be formed by ion injection, so as to enable a lower electrode of an initial storage capacitor to be formed at the region where the lower electrode of the storage capacitor is to be formed.

## Patentansprüche

1. Verfahren zum Herstellen eines Niedrigtemperatur-Polysilicium(LTPS)-Dünnfilmtransistors (TFT), umfassend einen Schritt zum Bilden einer aktiven Schicht und einer ohmschen Kontaktschicht auf einem Substrat, wobei der Schritt zum Bilden der aktiven Schicht und der ohmschen Kontaktschicht auf dem Substrat umfasst:
Bilden einer a-Si-Schicht auf dem Substrat;
Injizieren von Fremdionen in einen Bereich der a-Si-Schicht, in dem die ohmsche Kontaktschicht durch Ioneninjektion zu bilden ist, um eine anfängliche ohmsche Kontaktschicht an dem Bereich zu bilden, in dem die ohmsche Kontaktschicht zu bilden ist, und Unterlassen eines Injizierens der Fremdionen in einen anderen Bereich der a-Si-Schicht, der einem Bereich entspricht, der durch den LTPS-TFT belegt ist, zusätzlich zu dem Bereich der a-Si-Schicht, in dem die ohmsche Kontaktschicht zu bilden ist;
Unterziehen der a-Si-Schicht, die nach der Ioneninjektion erhalten wird, ohne einen Glühschritt dazwischen, einer Excimerlaser-Glühbehandlung, um die a-Si-Schicht in eine Polysiliciumschicht zu kristallisieren, die injizierten Ionen zu aktivieren und es der anfänglichen ohmschen Kontaktschicht zu ermöglichen, die endgültige ohmsche Kontaktschicht zu bilden; und
Strukturieren der Polysiliciumschicht, die nach der Excimerlaser-Glühbehandlung erhalten wird, um die aktive Schicht zu bilden, wobei in dem Bereich, der durch den LTPS-TFT belegt ist, die Polysiliciumschicht, die sich an einer Seite der ohmschen Kontaktschicht weiter entfernt von der aktiven Schicht befindet, vollständig entfernt wird.

2. Verfahren nach Anspruch 1, wobei die Excimerlaser-Glühbehandlung mit einer Laserpulsfrequenz von 100 bis 400 Hz, einem Laserüberlappungsverhältnis von 90 % bis 98 %, einer Laserpulsbreite von weniger als 100 ns und einer Laserenergiedichte von 100 bis 600 mJ/cm² durchgeführt wird.

3. Verfahren nach Anspruch 1 oder 2, wobei nachfolgend auf das Bilden der a-Si-Schicht und vor dem Injizieren der Fremdionen das Verfahren ferner ein Unterziehen der a-Si-Schicht einer Wärmeglühbehandlung umfasst.

4. Verfahren nach einem der Ansprüche 1 bis 3, wobei vor dem Bilden der a-Si-Schicht das Verfahren ferner ein Bilden einer Pufferschicht auf dem Substrat, um das gesamte Substrat abzudecken, umfasst.

5. Verfahren nach einem der Ansprüche 1 bis 4, wobei das Fremdion ein Bor- oder Phosphorion ist.

6. Verfahren nach einem der Ansprüche 1 bis 5, wobei das Substrat ein flexibles Substrat ist.

7. Verfahren zum Herstellen eines Array-Substrats, umfassend Schritte zum Bilden eines LTPS-TFT auf einem Substrat und Bilden einer unteren Elektrode eines Speicherkondensators, wobei der LTPS-TFT durch das Verfahren nach einem der Ansprüche 1 bis 6 gebildet wird.

8. Verfahren nach Anspruch 7, wobei der Schritt zum Bilden der unteren Elektrode des Speicherkondensators ein Injizieren von Fremdionen in einen Bereich der a-Si-Schicht, in dem die untere Elektrode des Speicherkondensators zu bilden ist, umfasst, während Fremdionen in den Bereich der a-Si-Schicht injiziert werden, in dem die ohmsche Kontaktschicht durch Ioneninjektion zu bilden ist, um es einer unteren Elektrode eines anfänglichen Speicherkondensators zu ermöglichen, an dem Bereich gebildet zu werden, in dem die untere Elektrode des Speicherkondensators zu bilden ist.

## Revendications

1. Procédé de fabrication d'un transistor en couches minces (TFT) en polysilicium basse température (LTPS), comprenant une étape consistant à former une couche active et une couche de contact ohmique sur un substrat, dans lequel l'étape consistant à former la couche active et la couche de contact ohmique sur le substrat comprend :
la formation d'une couche de a-Si sur le substrat ;
l'injection d'ions étrangers dans une région de la couche de a-Si où la couche de contact ohmique doit être formée par injection ionique, de manière à former une couche de contact ohmique initiale au niveau de la région où la couche de contact ohmique doit être formée, et l'abstention d'injection des ions étrangers dans une autre région de la couche de a-Si correspondant à une région occupée par le TFT LTPS en plus de la région de la couche de a-Si où la couche de contact ohmique doit être formée ;
la soumission de la couche de a-Si obtenue après l'injection ionique, sans étape de recuit entre elles, à un traitement de recuit par laser excimère de façon à cristalliser la couche de a-Si en une couche de polysilicium, activer les ions injectés et permettre à la couche de contact ohmique initiale de former la couche de contact ohmique finale ; et
la structuration de la couche de polysilicium obtenue après le traitement de recuit par laser excimère, de façon à former la couche active, dans lequel dans la région occupée par le TFT LTPS, la couche de polysilicium située au niveau d'un côté de la couche de contact ohmique éloignée de la couche active est retirée totalement.

2. Procédé selon la revendication 1, dans lequel le traitement de recuit par laser excimère est réalisé à une fréquence d'impulsion laser de 100 à 400 Hz, un rapport de chevauchement laser de 90 % à 98 %, une largeur d'impulsion laser inférieure à 100 ns, et une densité énergétique de laser de 100 à 600 mJ/cm².

3. Procédé selon la revendication 1 ou 2, dans lequel à la suite de la formation de la couche de a-Si et avant l'injection d'ions étrangers, le procédé comprend en outre la soumission de la couche de a-Si à un traitement de recuit thermique.

4. Procédé selon l'une quelconque des revendications 1 à 3, dans lequel avant la formation de la couche de a-Si, le procédé comprend en outre la formation d'une couche tampon sur le substrat de façon à couvrir le substrat dans sa totalité.

5. Procédé selon l'une quelconque des revendications 1 à 4, dans lequel l'ion étranger est un ion bore ou un ion phosphore.

6. Procédé selon l'une quelconque des revendications 1 à 5, dans lequel le substrat est un substrat flexible.

7. Procédé de fabrication d'un substrat de réseau, comprenant les étapes consistant à former un TFT LTPS sur un substrat et à former une électrode inférieure d'un condensateur de stockage, dans lequel le TFT LTPS est formé par le procédé selon l'une quelconque des revendications 1 à 6.

8. Procédé selon la revendication 7, dans lequel l'étape consistant à former l'électrode inférieure du condensateur de stockage comprend l'injection d'ions étrangers dans une région de la couche de a-Si où l'électrode inférieure du condensateur de stockage doit être formée, tout en injectant des ions étrangers dans la région de la couche de a-Si où la couche de contact ohmique doit être formée par injection ionique, de façon à permettre à une électrode inférieure d'un condensateur de stockage initial d'être formée au niveau de la région où l'électrode inférieure du condensateur de stockage doit être formée.
